(19) Europäisches Patentamt

European Patent Office

Office européen des brevets

(11) **EP 0 766 252 A2**

(12) **EUROPÄISCHE PATENTANMELDUNG**

(43) Veröffentlichungstag:
02.04.1997 Patentblatt 1997/14

(51) Int. Cl.$^6$: **G11C 7/06**, G11C 11/409

(21) Anmeldenummer: 96114903.6

(22) Anmeldetag: 17.09.1996

(84) Benannte Vertragsstaaten:
AT DE FR GB IE IT NL

(30) Priorität: 29.09.1995 DE 19536486

(71) Anmelder: **SIEMENS AKTIENGESELLSCHAFT**
**80333 München (DE)**

(72) Erfinder: **Rieger, Johann, Dipl.-Ing.**
**93199 Zell (DE)**

(54) **Bewerter- und Verstärkerschaltung**

(57) Bei der vorliegenden Erfindung ist die aus dem Stand der Technik her bekannte Bewerter- und Verstärkerschaltung doppelt ausgebildet. Dabei ist jedoch vorgesehen, daß die erfindungsgemäß neuen Teile der Bewerter- und Verstärkerschaltung zeitlich später schalten als die aus dem Stand der Technik her bekannten Schaltungsteile.

FIG 5

EP 0 766 252 A2

Printed by Rank Xerox (UK) Business Services
2.14.1/3.4

**Beschreibung**

Die Erfindung betrifft eine Bewerter- und Verstärkerschaltung nach dem Oberbegriff des Patentanspruches 1.

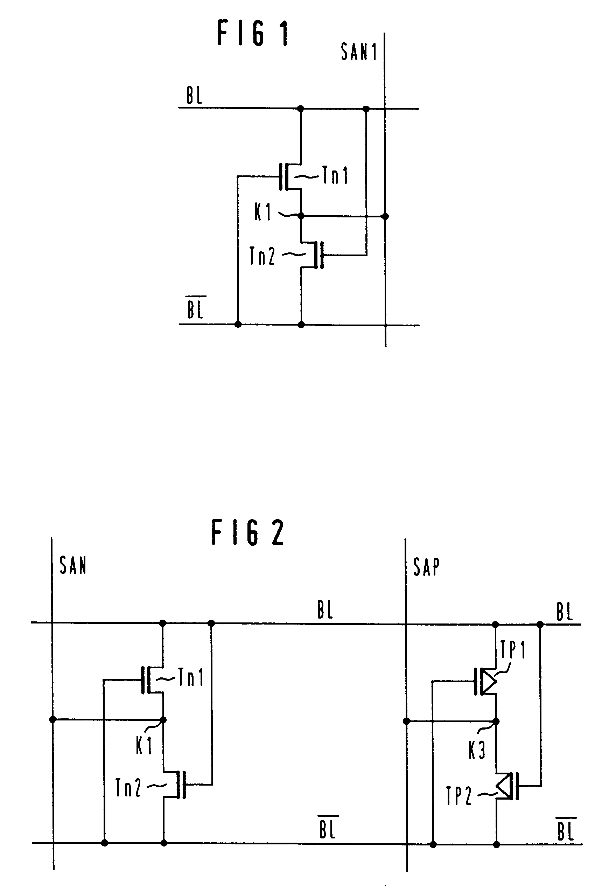

Solche Bewerter- und Verstärkerschaltungen werden insbesondere als (sogenannte externe oder interne) Leseverstärker in RAM's, vor allem in DRAM's eingesetzt. Gattungsgemäße Bewerter- und Verstärkerschaltungen zählen zumindest auf dem Gebiet von DRAM's zum allgemeinen Fachwissen. Figur 1 zeigt eine solche Schaltung. Dabei ist es im allgemeinen unerheblich, ob die beiden Transistoren der Bewerter- und Verstärkerschaltung vom p- oder vom n-Kanal-Typ sind.

Insbesondere beim Einsatz der bekannten Bewerter- und Verstärkerschaltungen (beispielsweise mit n-Kanal-Transistoren) als Leseverstärker von RAM's, bei dem diese gattungsgemäßen Bewerter- und Verstärkerschaltungen ja bekanntlich in einer Vielzahl je RAM eingesetzt werden, tritt nun aber das Problem auf, daß zwar solche als Leseverstärker eingesetzte Bewerter- und Verstärkerschaltungen, die, räumlich betrachtet, nahe an einer Leitung für ein erstes Versorgungspotential VSS (meist Masse) angeordnet sind, im Falle des Bewertens und Verstärkens eines einer sogenannten "physikalischen 1" entsprechenden Signals schnell bewerten und verstärken, daß jedoch solche als Leseverstärker eingesetzte Bewerter- und Verstärkerschaltungen (wiederum räumlich betrachtet), die weit weg von einer solchen Leitung für das erste Versorgungspotential VSS angeordnet sind, im Falle des Bewertens und Verstärkens einer sogenannten "physikalischen 0" (potentialmäßig näher beim Wert des ersten Versorgungspotentials VSS liegend als die "physikalische 1") demgegenüber relativ langsam bewerten und verstärken. Analoges gilt für gattungsgemäße Schaltungen mit p-Kanal-Transistoren. Bekanntlich bestimmen (unter anderem) die langsamsten Bewerter- und Verstärkerschaltungen die Arbeitsgeschwindigkeit der gesamten Schaltungsanordnung, in der sie enthalten sind, im Beispiel also die des jeweiligen RAM's.

Aufgabe der vorliegenden Erfindung ist es, eine Bewerter- und Verstärkerschaltung zu schaffen, die eine höhere Arbeitsgeschwindigkeit aufweist.

Diese Aufgabe wird bezüglich einer gattungsgemäßen Bewerter- und Verstärkerschaltung gelöst durch die kennzeichnenden Merkmale des Patentanspruches 1. Vorteilhafte Aus- und Weiterbildungen sind in Unteransprüchen gekennzeichnet.

Die Erfindung wird im folgenden anhand einer Zeichnung näher erläutert. Dabei zeigen

die Figuren 1 und 2 bekannte Bewerter- und Verstärkerschaltungen,

die Figur 3 sowohl eine erste wie auch eine dritte Ausführungsform der Erfindung,

die Figur 4 sowohl eine zweite wie auch eine vierte Ausführungsform der Erfindung und

die Figur 5 ein Timingdiagramm.

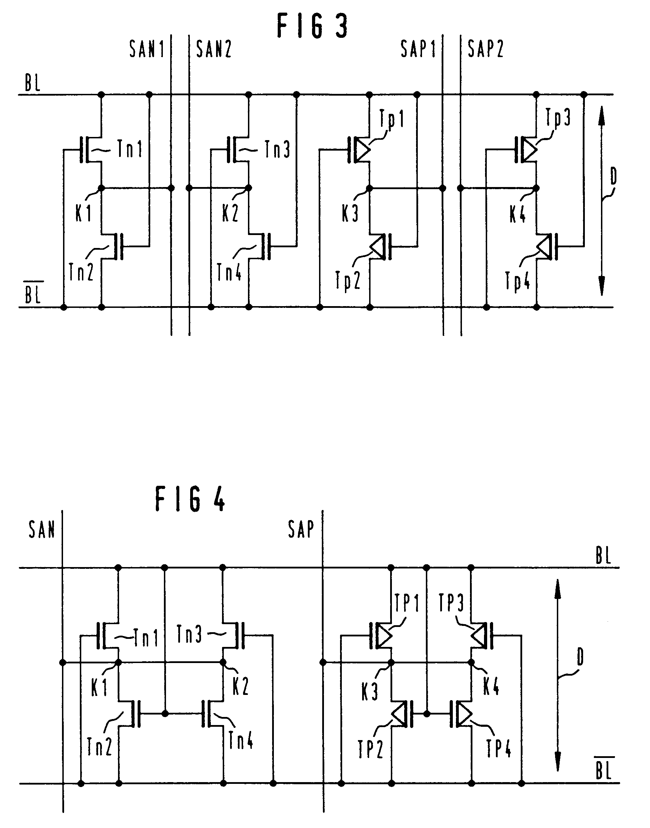

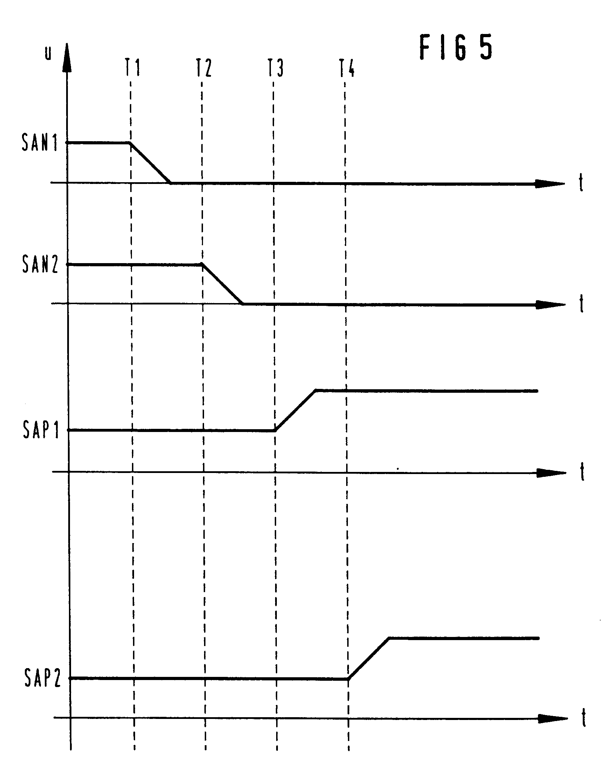

Zunächst wird anhand von Figur 3 eine erste Ausführungsform der Erfindung näher erläutert. Dabei sind die (in Figur 3 ebenfalls gezeigten) dritten Transistoren Tp1 bis Tp4 zu ignorieren. Der demnach zu betrachtende Teil von Figur 3 zeigt aus dem angegebenen Stand der Technik bereits bekannte erste Transistoren Tn1 und Tn2 vom n-Kanal-Typ, die in Serie zueinander zwischen zwei Signalleitungen BL, $\overline{BL}$ (bei RAM's allgemein als "Bitleitungshälften" bekannt) angeordnet sind. Ihre Gates sind wechselweise mit den beiden Signalleitungen BL, $\overline{BL}$ verbunden, d. h. das Gate des einen ersten Transistors Tn1 ist mit der anderen Signalleitung $\overline{BL}$ verbunden, während das Gate des anderen ersten Transistors Tn2 mit der einen Signalleitung BL verbunden ist. Die Verbindung zwischen den beiden ersten Transistoren Tn1, Tn2 bildet einen ersten Knoten K1, der mit einem ersten Steuersignal SAN1 beaufschlagbar ist (zum Zeitverlauf siehe Figur 5: Mittels der fallenden Flanke des ersten Steuersignals SAN1 wird der Bewertungs- und Verstärkungsvorgang eingeleitet). Erfindungsgemäß ist nun vorgesehen, daß parallel zu den ersten Transistoren Tn1, Tn2 zwei zweite Transistoren Tn3, Tn4 vom selben Kanaltyp wie die beiden ersten Transistoren Tn1, Tn2 angeordnet sind zwischen den beiden Signalleitungen BL, $\overline{BL}$. Ihre Gates sind ebenfalls wechselweise mit den beiden Signalleitungen BL, $\overline{BL}$ verbunden entsprechend den Gates der ersten beiden Transistoren Tn1, Tn2. Zwischen den beiden zweiten Transistoren Tn3, Tn4 ist ein zweiter Knoten K2 ausgebildet, der mit einem zweiten Steuersignal SAN2 beaufschlagbar ist.

Bei dieser Ausführungsform ist nun erfindungsgemäß vorgesehen, daß das zweite Steuersignal SAN2 gegenüber dem ersten Steuersignal SAN1 verzögert auftritt (vgl. dazu Figur 5), so daß die ersten beiden Transistoren Tn1, Tn2 bereits mit Bewerten und Verstärken eines an den beiden Signalleitungen BL, $\overline{BL}$ auftretenden Differenzsignales D (bei RAM's beispielsweise verursacht durch das Auslesen einer an die eine [oder beide] Signalleitung BL [bzw. Signalleitungen BL, $\overline{BL}$] angeschlossenen Speicherzelle) aufgrund der fallenden Flanke des ersten Steuersignals SAN1 begonnen haben, wenn die zweiten Transistoren Tn3, Tn4 (entsprechend einer fallenden Flanke des zweiten Steuersignals SAN2) mit dem Bewerten und Verstärken des nunmehr bereits teilweise bewerteten und verstärkten Differenzsignals D beginnen.

Selbstverständlich ist es auch möglich, anstelle der in Figur 3 betrachteten n-Kanal-Transistoren Tn1 bis Tn4 als erste bzw. zweite Transistoren auch solche vom p-Kanal-Typ zu verwenden. Dann sind bei diesem ersten Ausführungsbeispiel in Figur 3 stattdessen die p-Kanal-Transistoren Tp1 bis Tp4 zu betrachten mit den Knoten K3, K4 und den Steuersignalen SAP1, SAP2, welche allerdings im Gegensatz zu den Steuersignalen SAN1, SAN2 mit ansteigender Flanke die Bewertung und Verstärkung auslösen.

Figur 4 zeigt ein zweites (wie auch ein viertes) Ausführungsbeispiel der vorliegenden Erfindung. Bezüglich des zweiten Ausführungsbeispiels sind auch hier, entsprechend dem bezüglich der ersten Ausführungsform nach Figur 3 Gesagten, die Transistoren Tp1 bis Tp4 samt deren Steuersignal SAP zu ignorieren. Rein schaltungstechnisch unterscheidet sich dieses Ausführungsbeispiel vom ersten Ausführungsbeispiel dadurch, daß die in Figur 3 gezeigten beiden Steuersignale SAN1 und SAN2 durch ein einziges Steuersignal SAN ersetzt sind, das mit beiden Knoten K1 und K2 verbunden ist. Damit die beiden zweiten Transistoren Tn3, Tn4, wie gemäß dem Grundgedanken der Erfindung vorgesehen, mit der Bewertung und Verstärkung des Differenzsignals D erst nach Beginn der Bewertung und Verstärkung durch die beiden ersten Transistoren Tn1, Tn2 erfolgen kann, ist nun bei dieser Ausführungsform vorgesehen, daß die zweiten Transistoren Tn3, Tn4 Einsatzspannungen $U_{Tn3}$, $U_{Tn4}$ aufweisen, die entsprechend verschieden sind von den Einsatzspannungen $U_{Tn1}$, $U_{Tn2}$ der ersten beiden Transistoren Tn1, Tn2. Damit ist sichergestellt, daß der Beginn der Bewertung des Differenzsignals D durch die ersten Transistoren Tn1, Tn2 zu einem früheren Zeitpunkt erfolgt als durch die zweiten Transistoren Tn3, Tn4. Auch hier ist es selbstverständlich möglich, analog zu dem entsprechend Gesagten bezüglich der ersten Ausführungsform, daß die ersten und zweiten Transistoren vom p-Kanal-Typ sein können, d. h. also, daß in Figur 4 anstelle der Transistoren Tn1 bis Tn4 und des Steuersignals SAN die Transistoren Tp1 bis Tp4 samt Steuersignal SAP die Bewerter- und Verstärkerschaltung nach dem zweiten Ausführungsbeispiel bilden.

Die gesamte Figur 3, d. h. sämtliche Transistoren Tn1 bis Tn4 und Tp1 bis Tp4 sowie die Steuersignale SAN1, SAN2, SAP1, SAP2, bildet die dritte Ausführungsform der vorliegenden Erfindung. Aus dem allgemeinen Fachwissen, z. B. auf dem Gebiet von DRAM's, ist es nicht nur bekannt, daß die ersten Transistoren Tn1, Tn2 eine gattungsgemäße Bewerter- und Verstärkerschaltung bilden, sondern es ist darüber hinaus auch bekannt, daß Transistoren vom zu den ersten Transistoren Tn1, Tn2 entgegengesetzten Leitungstyp, nämlich dritte Transistoren Tp1, Tp2 einen weiteren Bestandteil dieser Bewerter- und Verstärkerschaltung bilden. Dies ist in Figur 2 dargestellt. Diese dritten Transistoren Tp1, Tp2 weisen ebenfalls einen gemeinsamen Knoten auf, den dritten Knoten K3, welcher mit einem dritten Steuersignal SAP1 beaufschlagbar ist. Eine steigende Flanke dieses dritten Steuersignals SAP1 löst im Betrieb bekanntlich den Bewerte- und Verstärkungsvorgang bezüglich des Differenzsignals D bei den dritten Transistoren Tp1, Tp2 aus. Die dritte Ausführungsform der vorliegenden Erfindung sieht nun (vgl. die gesamte Figur 3), in Ergänzung zu der bezüglich der ersten Ausführungsform bereits beschriebenen Anordnung aus den ersten und zweiten Transistoren Tn1 bis Tn4 und der Anordnung der dritten Transistoren Tp1, Tp2 wenigstens zwei vierte Transistoren Tp3, Tp4 vor, die vom selben Kanaltyp sind wie die dritten Transistoren Tp1, Tp2 und die, in Serie zueinander, ebenfalls zwischen den beiden Datenleitungen BL, $\overline{BL}$ geschaltet sind. Die dabei entstehende Verbindung zwischen den beiden vierten Transistoren Tp3, Tp4 bildet einen vierten Knoten K4, der mit einem vierten Steuersignal SAP2 beaufschlagbar ist. Erfindungsgemäß ist nun vorgesehen (vgl. Figur 5), daß die die Bewertung und Verstärkung des Differenzsignals D auslösende Flanke des vierten Steuersignals SAP2 (die bei Transistoren Tp3, Tp4 vom p-Kanal-Typ naturgemäß eine steigende Flanke ist) zeitlich später liegt als die entsprechende Flanke des dritten Steuersignals SAP1. Damit erfolgt auch das Bewerten und Verstärken des Datensignals D durch die vierten Transistoren Tp3, Tp4 zeitlich später als das Bewerten und Verstärken dieses Datensignals D durch die dritten Transistoren Tp1, Tp2.

Die gesamte Figur 4 (d. h. mit allen Transistoren Tn1 bis Tn4 und Tp1 bis Tp4) zeigt eine vierte Ausführungsform der Erfindung. Sie unterscheidet sich, rein schaltungstechnisch betrachtet, von der dritten Ausführungsform lediglich dadurch, daß das erste (SAN1) und das zweite Steuersignal SAN2 durch ein gemeinsames Steuersignal SAN ersetzt sind und daß das dritte (SAP1) und das vierte Steuersignal SAP2 durch ein gemeinsames weiteres Steuersignal SAP ersetzt sind. Die Einsatzspannungen der ersten (Tn1, Tn2) und der zweiten Transistoren Tn3, Tn4 sind voneinander verschieden entsprechend dem zweiten Ausführungsbeispiel. Darüber hinaus unterscheiden sich jedoch auch die Einsatzspannungen $U_{Tp1}$, $U_{Tp2}$ der dritten Transistoren Tp1, Tp2 entsprechend von den jeweiligen Einsatzspannungen $U_{Tp3}$, $U_{Tp4}$ der vierten Transistoren Tp3, Tp4. Somit ist auch bei dieser Ausführungsform sichergestellt, daß der Beginn von Bewertung und Verstärkung des Differenzsignals D durch die zweiten (Tn3, Tn4) und vierten Transistoren Tp3, Tp4 entsprechend später liegt als der jeweilige Beginn der Bewertung und Verstärkung durch die ersten (Tn1, Tn2) und dritten Transistoren Tp1, Tp2.

Figur 5 zeigt ein Timingdiagramm bezüglich der vorliegenden Erfindung, das primär die Verhältnisse bei der bereits beschriebenen dritten Ausführungsform zeigt: Die die Bewertung und Verstärkung auslösende (fallende) Flanke des zweiten Steuersignals SAN2 liegt zeitlich später als die entsprechende Flanke des ersten Steuersignals SAN1. Ebenso liegt die die Bewertung und Verstärkung auslösende (steigende) Flanke des vierten Steuersignals SAP2 zeitlich später als die entsprechende Flanke des dritten Steuersignals SAP1 (vgl. die jeweiligen Zeitpunkte T2, T1 und T4, T3). Derjenige Teil von Figur 5, der die Steuersignale SAN1, SAN2 zeigt, ist jedoch auch symptomatisch für die erste Ausführungsform.

Der unterschiedliche Zeitpunkt des Beginns von Bewerten und Verstärken durch die zweiten (Tn3, Tn4) bzw. vierten Transistoren Tp3, Tp4, bezogen auf die entsprechenden Zeitpunkte bei den ersten bzw. dritten Transistoren (Tn1, Tn2; Tp1, Tp2) ist selbstverständlich auch anderweitig vorgebbar, z. B. auch durch Wahl entsprechend unterschiedlicher Kanallängen und/oder Materialien und/oder Dotierungen der verwendeten Materialien bei den betreffenden Transistoren Tn1 bis Tn4, Tp1 bis Tp4 oder durch verschiedene Flankensteilheiten bei den ersten und zweiten bzw. dritten und vierten Steuersignalen SAN1, SAN2, SAP1, SAP2.

**Patentansprüche**

1. Bewerter- und Verstärkerschaltung nach Art eines getasteten Flipflops mit wenigstens zwei in Serie zueinanderliegenden ersten Transistoren (Tn1, Tn2; Tp1, Tp2) eines gegebenen Kanaltyps, die zwischen zwei Signalleitungen (BL, $\overline{BL}$) angeordnet sind,

   - bei der die Gates der ersten Transistoren (Tn1, Tn2; Tp1, Tp2) mit einer jeweiligen ($\overline{BL}$; BL) der beiden Signalleitungen (BL, $\overline{BL}$) verbunden sind und
   - bei der die ersten Transistoren (Tn1, Tn2; Tp1, Tp2) einen diesen gemeinsamen ersten Knoten (K1; K3) bilden, der mit einem ersten Steuersignal (SAN1; SAP1) beaufschlagbar ist,

   **dadurch gekennzeichnet,** daß

   - die Bewerter- und Verstärkerschaltung parallel zu den ersten Transistoren (Tn1, Tn2; Tp1, Tp2) eine Serienschaltung von wenigstens zwei zweiten Transistoren (Tn3, Tn4; Tp3, Tp4) vom selben Kanaltyp wie die ersten Transistoren (Tn1, Tn2; Tp1, Tp2) aufweist,
   - bei der die Gates ebenfalls wechselweise mit einer jeweiligen ($\overline{BL}$; BL) der beiden Signalleitungen (BL, $\overline{BL}$) verbunden sind,
   - bei der die zweiten Transistoren (Tn3, Tn4; Tp3, Tp4) einen diesen gemeinsamen zweiten Knoten (K2; K4) bilden, der mit einem zweiten Steuersignal (SAN2; SAP2) beaufschlagbar ist und
   - daß eine Bewertung und Verstärkung eines auf den Signalleitungen (BL, $\overline{BL}$) auftretenden Differenzsignals (D) durch die zweiten Transistoren (Tn3, Tn4; Tp3, Tp4) erst nach Beginn einer entsprechenden Bewertung und Verstärkung durch die ersten Transistoren (Tn1, Tn2; Tp1, Tp2) erfolgt.

2. Bewerter- und Verstärkerschaltung nach Anspruch 1, **dadurch gekennzeichnet,** daß der spätere Beginn der Bewertung und Verstärkung durch die zweiten Transistoren (Tn3, Tn4; Tp3, Tp4) dadurch bewirkt ist, daß eine die Bewertung und Verstärkung auslösende Flanke des zweiten Steuersignais (SAN2; SAP2) gegenüber einer entsprechenden Flanke des ersten Steuersignais (SAN1; SAP1) verzögert ist.

3. Bewerter- und Verstärkerschaltung nach Anspruch 1, **dadurch gekennzeichnet,** daß der spätere Beginn der Bewertung und Verstärkung durch die zweiten Transistoren (Tn3, Tn4; Tp3, Tp4) dadurch bewirkt ist, daß eine die Bewertung und Verstärkung auslösende Flanke des zweiten Steuersignals (SAN2; SAP2) gegenüber einer entsprechenden Flanke des ersten Steuersignals (SAN1; SAP1) eine geringere Flankensteilheit aufweist.

4. Bewerter- und Verstärkerschaltung nach Anspruch 1, **dadurch gekennzeichnet,** daß das erste (SAN1; SAP1) und das zweite Steuersignal (SAN2; SAP2) als ein einziges, gemeinsames Steuersignal (SAN; SAP) ausgebildet sind und daß der spätere Beginn der Bewertung und Verstärkung durch die zweiten Transistoren (Tn3, Tn4; Tp3, Tp4) dadurch bewirkt ist, daß die Einsatzspannung ($U_{Tn1}$, $U_{Tn2}$) der ersten Transistoren (Tn1, Tn2) verschieden ist von der Einsatzspannung ($U_{Tn3}$, $U_{Tn4}$) der zweiten Transistoren (Tn3, Tn4).

5. Bewerter- und Verstärkerschaltung nach Anspruch 1 oder 4, **dadurch gekennzeichnet,** daß die ersten Transistoren (Tn1, Tn2) und die zweiten Transistoren (Tn3, Tn4) verschiedene Kanallängen aufweisen.

6. Bewerter- und Verstärkerschaltung nach einem der vorhergehenden Ansprüche und mit wenigstens zwei dritten (Tp1, Tp2) Transistoren, die vom entgegengesetzten Kanaltyp sind wie die ersten Transistoren (Tn1, Tn2), **dadurch gekennzeichnet,**

   - daß sie wenigstens zwei vierte Transistoren (Tp3, Tp4) vom entgegengesetzten Kanaltyp aufweist,
   - daß die dritten und vierten Transistoren (Tp1 bis Tp4) entsprechend und parallel zu den ersten und zweiten Transistoren (Tn1 bis Tn4) zwischen den Signalleitungen (BL, $\overline{BL}$) angeordnet sind unter Bildung eines dritten (K3) und eines vierten Knotens (K4), die entsprechend mit einem dritten (SAP1) und einem vierten Steuersignal (SAP2) beaufsohlagbar sind und
   - daß eine Bewertung und Verstärkung des Differenzsignals (D) durch die vierten Transistoren (Tp3, Tp4) erst nach Beginn einer entsprechenden Bewertung und Verstärkung durch die dritten Transistoren (Tp1, Tp2) erfolgt.

7. Bewerter- und Verstärkerschaltung nach Anspruch 6, **dadurch gekennzeichnet,** daß der spätere Beginn der Bewertung und Verstärkung durch die vierten Transistoren (Tp3, Tp4) dadurch bewirkt ist, daß eine die Bewertung und Verstärkung auslösende Flanke des vierten Steuersignals (SAP2) gegenüber einer entsprechenden Flanke des dritten Steuersignals (SAP1) verzögert ist.

8. Bewerter- und Verstärkerschaltung nach Anspruch 6, **dadurch gekennzeichnet,** daß der spätere Beginn der Bewertung und Verstärkung durch die vierten Transistoren (Tp3, Tp4) dadurch bewirkt ist, daß eine die Bewertung und Verstärkung auslösende Flanke des vierten Steuersignals (SAP2) gegenüber einer entsprechenden Flanke des dritten Steuersignals (SAP1) eine geringere Flankensteilheit aufweist.

9. Bewerter- und Verstärkerschaltung nach Anspruch 6, **dadurch gekennzeichnet,** daß das dritte (SAP1) und das vierte Steuersignal (SAP2) als ein einziges gemeinsames Steuersignal (SAP) ausgebildet sind und daß der spätere Beginn des Bewertens und Verstärkens durch die vierten Transistoren (Tp3, Tp4) dadurch bewirkt ist, daß die Einsatzspannungen ($U_{Tp1}$, $U_{Tp2}$) der dritten Transistoren (Tp1, Tp2) verschieden sind von den Einsatzspannungen ($U_{Tp3}$, $U_{Tp4}$) der vierten Transistoren (Tp3, Tp4).

10. Bewerter- und Verstärkerschaltung nach Anspruch 6 oder 9, **dadurch gekennzeichnet,** daß die dritten Transistoren (Tp1, Tp2) und die vierten Transistoren (Tp3, Tp4) verschiedene Kanallängen aufweisen.

# FIG 1

# FIG 2

# F I G 3

# F I G 4

FIG 5